**Europäisches Patentamt**

**European Patent Office**

**Office européen des brevets**

(19)

(11) Numéro de publication : **0 093 651**
**B1**

(12)

# FASCICULE DE BREVET EUROPÉEN

(45) Date de publication du fascicule du brevet :
07.05.86

(51) Int. Cl.⁴ : **H 03 G  3/20**

(21) Numéro de dépôt : **83400824.5**

(22) Date de dépôt : **26.04.83**

(54) Récepteur de signaux multiportéuses protégé des signaux perturbateurs.

(30) Priorité : **04.05.82 FR 8207754**

(43) Date de publication de la demande :
**09.11.83 Bulletin 83/45**

(45) Mention de la délivrance du brevet :
**07.05.86 Bulletin 86/19**

(84) Etats contractants désignés :
**DE GB IT NL SE**

(56) Documents cités :
**US-A- 3 042 800**
**US-A- 4 126 828**
**PATENTS ABSTRACTS OF JAPAN, vol. 5, no. 40, 17
mars 1981, page 127E49**

(73) Titulaire : **THOMSON-CSF**
**173, Boulevard Haussmann**
**F-75379 Paris Cedex 08 (FR)**

(72) Inventeur : **Carpe, Michel**
**THOMSON-CSF SCPI 173, bld Haussmann**
**F-75379 Paris Cedex 08 (FR)**
Inventeur : **Collin, Claude**
**THOMSON-CSF SCPI 173, bld Haussmann**
**F-75379 Paris Cedex 08 (FR)**
Inventeur : **Pontif, Marc**
**THOMSON-CSF SCPI 173, bld Haussmann**
**F-75379 Paris Cedex 08 (FR)**

(74) Mandataire : **Weinmiller, Jürgen et al**
**Zeppelinstrasse 63**
**D-8000 München 80 (DE)**

## Description

L'invention se rapporte aux équipements de transmission de type multiporteuses, et plus particulièrement à un récepteur adapté à ce type de transmission protégé des signaux perturbateurs.

Lors de la réception de signaux composés de plusieurs porteuses modulées, l'un des problèmes à résoudre concerne la protection contre les effets des perturbateurs.

Pour la réception de signaux composés de plusieurs porteuses modulées, il n'est pas rentable d'utiliser une voie de réception par fréquence porteuse. Le récepteur comprend donc généralement des circuits à haute fréquence et à fréquence intermédiaire communs à toutes les porteuses modulées, et pour chaque porteuse un circuit particulier permettant la démodulation. Un tel récepteur est par exemple décrit dans le brevet US-A-3 042 800.

L'amplificateur en fréquence intermédiaire commun à toutes les porteuses est un amplificateur à commande automatique de gain, dont le gain est commandé par une tension proportionnelle à l'enveloppe du signal reçu ayant le niveau le plus élevé parmi les signaux transmis sur les différentes porteuses. Cette disposition permet d'obtenir, dans des conditions normales, un fonctionnement linéaire de l'amplificateur à commande de gain.

En sortie de cet amplificateur, le signal est aiguillé sur les différentes voies accordées sur les fréquences à démoduler. Un circuit de commande recevant les tensions détectées sur les différentes voies sélectionne en permanence la tension détectée la plus élevée pour l'appliquer à l'entrée de commande de gain de l'amplificateur à fréquence intermédiaire.

En présence d'un signal perturbateur, la protection d'un tel récepteur est donnée par les filtrages successifs en haute fréquence et en fréquence intermédiaire avant l'amplification, et par le filtrage à bande étroite centré sur chacune des fréquences intermédiaires. Lorsque le perturbateur a une fréquence située à l'intérieur de la bande passante des filtres à bande étroite la perturbation est maximum. De plus, lorsque la tension détectée maximum est celle correspondant à la voie dont la fréquence porteuse est voisine de la fréquence du signal perturbateur, c'est cette tension détectée maximum qui est prise comme référence pour la commande de gain de l'amplificateur à fréquence intermédiaire. En conséquence, pour un niveau croissant du signal perturbateur, le gain de l'amplificateur à fréquence intermédiaire diminue, donc le niveau du signal avant démodulation diminue jusqu'à atteindre la valeur limite admissible pour un bon fonctionnement des démodulateurs. Le niveau du signal perturbateur maximum admissible est déterminé en fonction du niveau des signaux utiles, qui doivent être maintenus au-dessus du seuil inférieur de la dynamique du démodulateur.

Un tel récepteur résiste classiquement à des perturbateurs dont la fréquence est voisine de l'une des fréquences reçues, et dont le niveau maximum admissible est de l'ordre de 20 décibels au-dessus du signal utile de niveau le plus élevé, compte-tenu du fait que la dynamique du démodulateur a un seuil inférieur de l'ordre de − 30 dB par rapport au niveau nominal.

La présente invention a pour objet un récepteur de signaux protégé des perturbations, l'écart entre le signal perturbateur et le signal utile de niveau le plus élevé pouvant atteindre 80 décibels, la fréquence du perturbateur étant proche voire égale à une des fréquences reçues.

Suivant l'invention, un récepteur de signaux multiporteuses comportant des circuits d'amplification à haute fréquence et à fréquence intermédiaire communs à l'ensemble de n porteuses modulées et un circuit de démodulation comportant pour chaque porteuse modulée un filtre, un amplificateur détecteur présentant des sorties de signaux détectés, et un démodulateur présentant des sorties de signaux démodulés, est caractérisé en ce que, pour la protection contre les signaux perturbateurs, le récepteur comporte en outre un circuit de détection des perturbateurs couplé aux sorties du circuit de démodulation et fournissant des signaux de commande caractéristiques de l'apparition ou de la disparition d'un signal perturbateur sur chacune des voies, et un circuit de présélection et d'atténuation sélective des porteuses en fréquence intermédiaire inséré entre le circuit à haute fréquence et le circuit à fréquence intermédiaire, le circuit de présélection et d'atténuation comportant des filtres accordés sur les porteuses en fréquence intermédiaire suivis d'atténuateurs commandés par les signaux de commande, ainsi que d'un additionneur.

L'invention sera mieux comprise et d'autres caractéristiques apparaîtront à l'aide de la description qui suit en référence aux figures annexées.

La figure 1 représente le schéma classique d'un récepteur multiporteuses.

La figure 2 est un diagramme schématique du spectre des fréquences.

La figure 3 est le schéma du récepteur multiporteuses protégé des perturbations suivant l'invention.

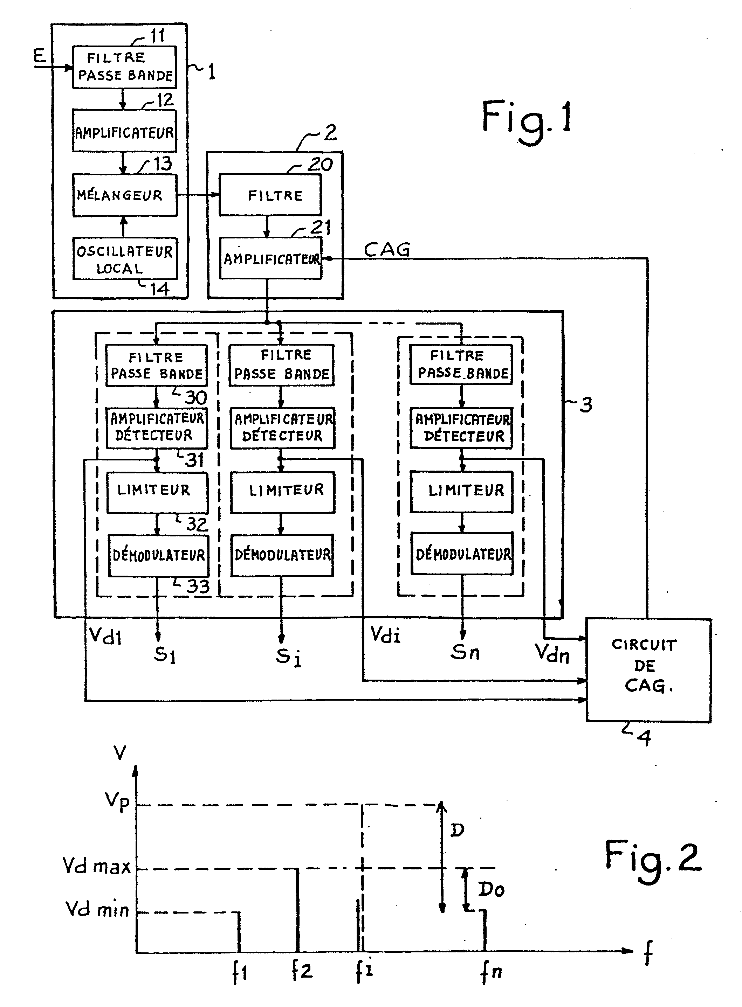

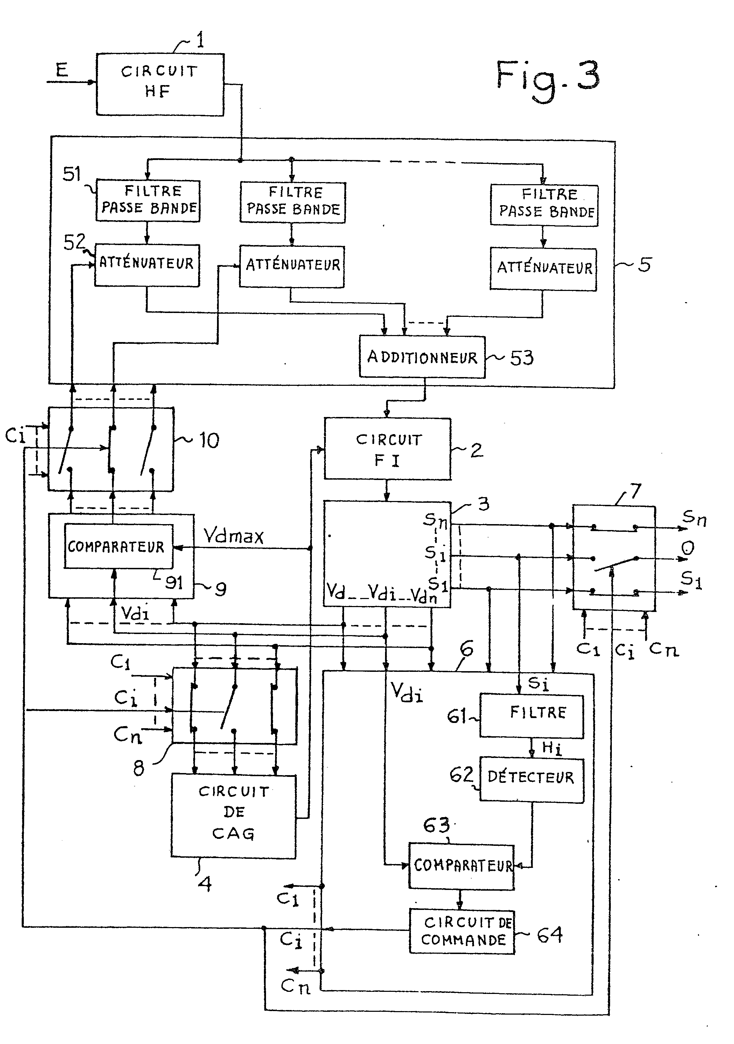

Sur les figures 1 et 3, les éléments analogues sont indiqués par les mêmes références.

Le récepteur multiporteuses classique représenté sur la figure 1, comporte des circuits à haute fréquence 1, des circuits en fréquence intermédiaire 2, des circuits d'amplification, de détection et de démodulation 3.

Les circuits haute fréquence 1 comportent un filtre passe bande 11 couplé à l'entrée E du récepteur, dont la sortie est reliée à l'entrée d'un amplificateur 12 ayant sa sortie reliée à la première entrée d'un mélangeur 13. La seconde entrée du mélangeur est reliée à la sortie d'un oscillateur local 14. La sortie du mélangeur fournit le signal à fréquence intermédiaire appliqué à l'entrée des circuits à fréquence intermédiaire 2 qui comportent un filtre passe bande 20 suivi d'un amplificateur à fréquence intermédiaire 21. Cet amplificateur est un amplificateur à commande automatique de gain ayant une entrée de CAG. La sortie de cet amplificateur 21 constitue la sortie des circuits à fréquence intermédiaire et est reliée à l'entrée des circuits de démodulation 3. Ces circuits de démodulation comportent, pour chaque porteuse, un filtre passe bande 30 accordé sur la fréquence de la voie correspondante, $f_1$, $f_2$ ... $f_n$, la sortie de ce filtre passe bande étant reliée à l'entrée d'un amplificateur détecteur 31 dont la sortie est reliée à un circuit limiteur 32. Un démodulateur 33 a son entrée reliée à la sortie du limiteur et sa sortie délivre le signal démodulé, $S_i$, i = 1 à n.

Il a été indiqué ci-dessus que l'amplificateur à fréquence intermédiaire à commande automatique de gain était commandé par la tension détectée maximum des différentes porteuses. Pour cela, les sorties des amplificateurs détecteurs 31, fournissant les tensions détectées $V_{d1}$, $V_{d2}$ ... $V_{dn}$, sont reliées aux entrées d'un circuit de commande automatique de gain 4. Ce circuit sélectionne parmi les tensions appliquées sur ses différentes entrées, celles dont le niveau est le plus élevé, et la transmet, avec un gain convenable, à l'entrée de commande automatique de gain de l'amplificateur à fréquence intermédiaire 21.

La figure 2 représente les niveaux détectés dans les différentes voies à fréquences porteuses $f_1$, $f_2$, ... $f_i$ ... $f_n$. Soit $V_{dmin}$ et $V_{dmax}$ les tensions détectées minimale et maximale sur les différentes voies. $D_0$ est l'écart entre les deux tensions détectées extrêmes, et est généralement de l'ordre de 10 dB.

A titre d'exemple sur cette figure un signal perturbateur de niveau $V_p$ a été représenté en pointillés à une fréquence voisine de la fréquence $f_i$ de la voie i. Soit D la dynamique utile des limiteurs permettant un bon fonctionnement des démodulateurs. Dans un récepteur classique, D est de l'ordre de 30 décibels, la différence $D-D_0$ égale à 20 décibels fixe le niveau maximum admissible du signal perturbateur à 20 décibels au-dessus du signal utile le plus élevé. Si le niveau est dépassé, le signal à l'entrée des démodulateurs devient inférieur à leur seuil de bon fonctionnement ; toutes les voies sont affectées par ce perturbateur.

La figure 3 représente le récepteur suivant l'invention. Il comporte comme le récepteur classique des circuits haute fréquence 1 dont l'entrée est couplée à l'entrée E du récepteur et dont la sortie est couplée à l'entrée des circuits à fréquence intermédiaire 2. Mais, entre les circuits haute fréquence et les circuits à fréquence intermédiaire, le récepteur suivant l'invention comporte un circuit de présélection et d'atténuation sélective en fréquence, 5, constitué de la manière suivante. La sortie des circuits haute fréquence 1 est reliée aux entrées de n filtres passe bande, centrés respectivement sur les fréquences porteuses des différentes voies. Chaque filtre passe bande 51 est suivi d'un atténuateur 52 à commande électronique dont l'atténuation maximale peut dépasser 80 décibels, l'atténuation résiduelle étant de quelques décibels. Les sorties de ces atténuateurs sont reliées aux entrées d'un additionneur 53. Les filtres passe bande de ce circuit de présélection, centrés sur les fréquences $f_i$, ont une largeur de bande suffisante pour transmettre le signal modulé, et ont un affaiblissement permettant d'éliminer les fréquences voisines des fréquences $f_i$. La sortie de l'additionneur 53 est reliée à l'entrée des circuits à fréquence intermédiaire 2. La sortie de ces circuits est reliée, comme dans le récepteur classique, à l'entrée d'un circuit de détection et de démodulation 3, à n voies séparées. Ce circuit 3 fournit comme précédemment les signaux de sortie démodulés $S_1$ ... $S_n$, et les tensions détectées $V_{d1}$ ... $V_{dn}$. Le récepteur suivant l'invention comporte en outre un circuit de détection de la voie perturbée, 6, qui reçoit les tensions détectées $V_{di}$ et les signaux de sortie $S_i$, de i = 1 à n. Le signal utile démodulé $S_i$ de la voie i contient une information caractéristique $H_i$ permettant de l'identifier comme un signal effectivement émis. Cette information peut être une fréquence pilote lorsque le circuit transmet des signaux analogiques, ou la fréquence horloge récupérée pour une transmission de signaux numériques.

Ces fréquences pures, connues du récepteur, sont sélectionnées par filtrage et détectées. Pour cela, le circuit de détection de la voie perturbée 6 comporte pour chaque voie, un filtre 61 dont l'entrée est reliée à la sortie de signal démodulé correspondante, suivi d'un détecteur 62. La sortie du détecteur 62 et la sortie de signal détecté $V_{di}$ de la voie correspondante du circuit de détection et de démodulation 3 sont reliées aux entrées d'un comparateur 63. Ce circuit comparateur 63 fonctionne de la manière suivante : en l'absence de signal perturbateur le niveau d'horloge détecté $H_i$ est élevé, tandis que lorsqu'un perturbateur apparaît, ce niveau d'horloge détecté décroît rapidement. De plus, la tension détectée $V_{di}$ en l'absence de signal perturbateur reste inférieure au niveau détecté d'horloge, alors que, lorsqu'un signal perturbateur apparaît, la tension détectée $V_{di}$ reste à fort niveau tandis que le niveau d'horloge détecté est faible. Le comparateur 63 est un amplificateur différentiel qui fournit sur sa sortie un signal positif ou négatif selon qu'un signal perturbateur est apparu sur la voie i correspondante ou non. La sortie du circuit comparateur 63 est reliée à l'entrée d'un circuit de commande 64, (circuit logique à seuil 0 volt) dont la sortie délivre des impulsions de commande d'ouverture ou de fermeture à des interrupteurs de la manière suivante :

Tout d'abord les sorties $S_i$ du circuit de détection et de démodulation 3 sont reliées aux entrées du circuit de traitement du récepteur (non représenté) par des interrupteurs à commande électronique 7. Ce circuit de traitement est par exemple un circuit de combinaison des signaux des diffé- rentes voies pour un récepteur fonctionnant en diversité de fréquences. La sortie du circuit de commande 64 de la voie i est reliée à l'entrée de commande de l'interrupteur correspondant, l'interrupteur étant fermé lorsqu'aucun signal perturbateur n'a été détecté par le circuit comparateur, l'interrupteur 7 étant au contraire ouvert lorsqu'un signal perturbateur a été détecté puis refermé lorsque ce signal perturbateur a disparu. Cette information est donnée par la sortie du comparateur 63 via le circuit de commande 64.

De plus, les sorties de signal détecté $V_{di}$ sont reliées aux entrées du circuit de commande automatique de gain, CAG, 4 par l'intermédiaire d'interrupteurs à commande électronique 8. L'entrée de commande de l'interrupteur correspondant à la voie d'indice i est reliée à la sortie $C_i$ du circuit de commande correspondant. Lorsqu'un signal perturbateur est apparu sur la voie d'indice i, l'interrupteur correspondant est ouvert, de façon que la tension détectée $V_{di}$ ne contribue pas à l'élaboration de la tension de commande de gain de l'amplificateur à commande automatique de gain. Ainsi, la sortie du circuit de CAG 4 délivre à l'entrée de commande automatique de gain la tension $V_{dmax}$ égale à la tension détectée la plus élevée de toutes les voies hormis celle de la voie i dans laquelle un signal perturbateur a été détecté.

A l'arrivée d'un signal perturbateur, le circuit 6 détecte donc la voie i perturbée par disparition de la fréquence pilote ou horloge alors que le signal détecté a un niveau élevé, et élimine par l'intermédiaire des interrupteurs 7 et 8 la contribution de la voie i dans le signal démodulé d'une part et pour l'élaboration de la tension de commande automatique de gain du circuit à fréquence intermédiaire d'autre part.

Néanmoins, avec un tel circuit, le signal perturbateur subsiste à fort niveau à l'entrée de l'amplificateur à fréquence intermédiaire. Il est donc nécessaire de l'atténuer pour éviter la formation de produits d'intermodulation dans cet amplificateur intermédiaire commun aux n porteuses. En effet, un signal perturbateur à fort niveau à l'entrée de l'amplificateur à fréquence intermédiaire sature l'amplificateur qui travaille alors dans une zone non linéaire et génère des produits d'intermodulation. Compte tenu de la proximité des fréquences des différentes voies et de l'espacement régulier qui existe généralement entre ces fréquences, les produits d'intermodulation générés par la non linéarité de l'amplificateur à fréquence intermédiaire sont des produits du type 2 $f_k$-$f_i$, k et i étant les indices des deux porteuses voisines. Ces produits peuvent se situer aux alentours d'une fréquence $f_j$ voisine des deux premières.

Pour résoudre ce problème, une première solution consiste à couper la voie d'indice i à l'entrée de l'amplificateur à fréquence intermédiaire en commandant une atténuation $A_i$ très élevée de l'atténuateur 52 correspondant de la voie i. Cette solution permet d'éviter le problème ci-dessus mais à l'inconvénient de ne plus donner d'information sur la présence du signal perturbateur. Pour obtenir cette information il est donc nécessaire dans un circuit de ce type de remettre en service périodiquement la voie i, pour s'assurer que le signal perturbateur existe toujours, ou au contraire qu'il a disparu ; dans ce dernier cas les interrupteurs 7 et 8 correspondants doivent être à nouveau fermés.

Une deuxième solution correspondant au mode de réalisation préféré de l'invention représenté sur la figure 3, consiste à introduire une atténuation avant amplification en fréquence intermédiaire, sur la voie d'indice i dans laquelle un signal perturbateur a été détecté, cette atténuation étant variable avec le niveau de perturbation d'une part, et les niveaux détectés des autres voies d'autre part. Cette solution permet de ramener le signal perturbateur à l'entrée de l'amplificateur à fréquence intermédiaire à un niveau tel que les non linéarités soient évitées, éliminant ainsi tout risque d'intermodulation, mais en gardant ce signal perturbateur à un niveau compris dans la dynamique du démodulateur, par exemple au niveau le plus élevé des n-1 autres fréquences porteuses utiles.

A cet effet, le récepteur suivant l'invention comporte un circuit de comparaison 9 comportant n comparateurs tels que 91, recevant d'une part la tension détectée $V_{di}$ de la voie correspondante, et d'autre part la tension détectée maximum $V_{dmax}$ des tensions détectées dans les voies non perturbées. Cette tension $V_{dmax}$ n'est autre que la tension de sortie du circuit de commande automatique de gain 4. Le comparateur 91 délivre alors un signal proportionnel à $V_{dmax}$-$V_{di}$ transmis ou non à l'atténuateur 52 correspondant de la voie i selon que l'interrupteur correspondant du circuit d'interruption 10 est ouvert ou fermé ; cette commande des interrupteurs 10 est réalisée par les signaux de commande $C_i$. Ainsi, après atténuation dans la voie i dans laquelle le signal perturbateur a été détecté, le niveau dans la voie perturbée est égal au niveau maximum détecté dans les autres voies, et le circuit de détection de signal perturbateur fournit en permanence l'information de présence de ce signal perturbateur, le signal détecté dans cette voie ayant un niveau relativement élevé tandis que le niveau d'horloge du signal récupéré dans cette même voie est très faible. Lors de la disparition du signal perturbateur, le niveau d'horloge redevient élevé par rapport au niveau du signal détecté dans cette même voie et le signal de commande change d'état ; les interrupteurs correspondants 7 et 8 se referment tandis que l'interrupteur 10 commandant l'atténuation s'ouvre.

Avec des atténuateurs électroniques à diode PIN, il est possible de réaliser une atténuation $A_i$ de l'ordre de 80 décibels. En conséquence, le récepteur décrit ci-dessus est protégé pour des signaux perturbateurs dont la fréquence est voisine ou égale à l'une des fréquences reçues et dont le niveau maximum est de l'ordre de 80 décibels au-dessus du signal utile ayant le niveau le plus élevé. Ces chiffres sont typiquement ceux qui correspondent à une diffusion troposphérique ou ionosphérique, perturbée par des signaux reçus en vue directe.

Ainsi, un récepteur multiporteuses du type décrit ci-dessus continue à fonctionner dans de bonnes conditions avec des signaux perturbateurs, l'amélioration apportée étant de l'ordre de 60 décibels par rapport au système classique décrit ci-dessus.

L'invention s'applique aux équipements de transmission de type multiporteuses et en particulier aux radiocommunications par satellites, aux radiocommunications troposphériques ou ionosphériques en diversité de fréquences, ou aux radiocommunications à partir de véhicules mobiles, en diversité de fréquences.

**Revendications**

1. Récepteur de signaux multiporteuses (figure 3) comportant des circuits d'amplification à haute fréquence (1) et à fréquence intermédiaire (2) communs à l'ensemble de n porteuses modulées et un circuit de démodulation (3) comportant pour chaque porteuse modulée un filtre (30, figure 1), un amplificateur détecteur (31, figure 1) présentant des sorties de signaux détectés ($V_{di}$), et un démodulateur (33, figure 1) présentant des sorties de signaux démodulés ($S_i$), caractérisé en ce que, pour la protection contre les signaux perturbateurs, le récepteur comporte en outre un circuit de détection des perturbateurs (6) couplé aux sorties ($V_{di}$, $S_i$, i = 1 à n) du circuit de démodulation et fournissant des signaux de commande ($C_i$) caractéristiques de l'apparition ou de la disparition d'un signal perturbateur sur chacune des voies, et un circuit de présélection et d'atténuation sélective (5) des porteuses en fréquence intermédiaire inséré entre le circuit à haute fréquence (1) et le circuit à fréquence intermédiaire, le circuit de présélection et d'atténuation (5) comportant des filtres (51) accordés sur les porteuses en fréquence intermédiaire suivis d'atténuateurs (52) commandés par les signaux de commande ($C_i$), ainsi qu'un additionneur (53) desdites porteuses.

2. Récepteur selon la revendication 1 dans lequel l'amplificateur à fréquence intermédiaire est commandé par un circuit de commande automatique de gain (4) dont les entrées sont couplées aux sorties des amplificateurs détecteurs (31) et dont la sortie suit la tension détectée la plus élevée présente sur ces sorties, caractérisé en ce qu'il comporte en outre, entre les sorties des amplificateurs détecteurs (31) et les entrées du circuit de commande automatique de gain (4), des interrupteurs (8) à commande électronique commandés par les signaux de commande ($C_i$) pour empêcher la transmission du signal détecté sur une voie perturbée au circuit de commande automatique de gain.

3. Récepteur selon l'une des revendications 1 et 2 fonctionnant en diversité de fréquences et comportant un circuit de combinaison des porteuses démodulées couplé aux sorties du circuit de démodulation, caractérisé en ce que des interrupteurs (7) à commande électronique commandés par les signaux de commande ($C_i$) sont placés entre les sorties du circuit de démodulation et le circuit de combinaison pour annuler le signal de sortie d'une voie perturbée.

4. Récepteur selon l'une quelconque des revendications précédentes, caractérisé en ce que le circuit (6) de détection des perturbations comporte pour chaque porteuse un circuit (61, 62) de récupération et de détection de signal horloge ($H_i$) dont l'entrée est reliée à la sortie correspondante ($S_i$) du circuit de démodulation, un comparateur (63) dont les entrées sont reliées à la sortie de signal détecté ($V_{di}$) correspondante et à la sortie du circuit de détection de signal horloge, et un circuit de commande (64) qui, à partir des niveaux relatifs du signal horloge et du signal détecté, fournit le signal de commande ($C_i$) correspondant.

5. Récepteur selon l'une quelconque des revendications précédentes, caractérisé en ce que l'atténuation sélective en fréquence commandée par le signal de commande correspondant lors d'une apparition de signal perturbateur sur la porteuse correspondante est une atténuation maximum, les atténuateurs (52) étant mis en circuit par fermeture d'interrupteurs (10) commandés par les signaux de commande ($C_i$), le récepteur comportant en outre un dispositif de commande de test de la porteuse correspondante pour le changement d'état du signal de commande correspondant lors de la disparition du signal perturbateur.

6. Récepteur selon l'une quelconque des revendications 1 à 4, caractérisé en ce que l'atténuation, sélective en fréquence, commandée par le signal de commande correspondant lors d'une apparition d'un signal perturbateur sur la porteuse correspondante est une atténuation variable ramenant l'amplitude du signal perturbateur à l'entrée du circuit à fréquence intermédiaire (2) à un niveau compris dans la dynamique des voies non perturbées, les atténuateurs étant mis en circuit par fermeture d'interrupteurs (10) commandés par les signaux de commande ($C_i$) et appliquant un signal d'amplitude variable aux atténuateurs.

7. Récepteur selon la revendication 6, caractérisé en ce que le niveau d'une porteuse perturbée est ramené par l'atténuateur variable correspondant commandable en tension au niveau de la porteuse de niveau maximum parmi les porteuses non perturbées, le récepteur comportant, pour chaque voie, un circuit de comparaison (91) du niveau de la porteuse détectée et du niveau de la porteuse détectée non perturbée de niveau maximum dont la sortie est reliée par un interrupteur (10) à l'entrée de commande en tension de l'atténuateur.

**Claims**

1. A multicarrier signal receiver (fig. 3) comprising high frequency and intermediate frequency amplification circuits (1 and 2 respectively), which are common for all the n modulated carriers, and a demodulation circuit (3) comprising for each modulated carrier a filter (30, fig. 1), an amplifier-detector (31, fig. 1) delivering detected signals ($V_{di}$) and a demodulator (33, fig. 1) delivering demodulated signals ($S_i$), characterized in that in view of the protection against the disturbance signals, the receiver further comprises a circuit for detecting disturbances (6) coupled to the outputs ($V_{di}$, $S_i$, i = 1 to n) of the demodulation circuit and supplying control signals ($C_i$) which are characteristic for the appearance or the disappearance of a disturbance signal on any of the channels, and a circuit (5) for preselection and selective attenuation of the intermediate frequency carriers, this circuit being inserted between the high frequency circuit (1) and the intermediate frequency circuit, the preselection and attenuation circuit (5) comprising filters (51) which are tuned to the intermediate frequency carriers and which are followed by attenuators (52) controlled by control signals, the receiver also comprising an adder (53) for adding said carriers.

2. A receiver according to claim 1, in which the intermediate frequency amplifier is controlled by an automatic gain control circuit (4), the inputs of which are coupled to the outputs of the amplifier-detectors (31) and the output of which follows the highest detected voltage which is present at these outputs, characterized in that it further comprises, between the outputs of the amplifier detectors (31) and the inputs of the automatic gain control circuit (4), electronically controlled interruptors (8) which are controlled by the control signals ($C_i$) for blocking the transmission of the signal detected on a disturbed channel to the automatic gain control circuit.

3. A receiver according to one of claims 1 and 2, operating in the frequency diversity mode and comprising a circuit for combining the demodulated carriers, this circuit being coupled to the outputs of the demodulation circuit, characterized in that electronically controlled interruptors (7) which are controlled by the control signals ($C_i$) are located between the outputs of the demodulation circuit and the combination circuit for cancelling the output signal of a disturbed channel.

4. A receiver according to any one of the preceding claims, characterized in that the circuit (6) for detecting the disturbances comprises for each carrier a clock signal ($H_i$) recovery and detection circuit (61, 62), the input of which is connected to the corresponding output ($S_i$) of the demodulation circuit, a comparator (63), the inputs of which are connected to the corresponding output for the detected signal ($V_{di}$) and to the output of the clock signal detection circuit, and a control circuit (64) furnishing the corresponding control signal ($C_i$) on the basis of the relative levels of the clock signal and the detected signal.

5. A receiver according to any one of the preceding claims, characterized in that the selective frequency attenuation controlled by the corresponding control signal at the appearance of a disturbance signal on the corresponding carrier, is a maximum attenuation, the attenuators (52) being switched in by closing interruptors (10) which are controlled by the control signals ($C_i$), the receiver moreover comprising a test control device for testing the corresponding carrier in order to change the state of the corresponding control signal if the disturbance signal disappears.

6. A receiver according to any one of claims 1 to 4, characterized in that the frequency selective attenuation, controlled by the corresponding control signal at the appearance of a disturbance signal on the corresponding carrier, is a variable attenuation bringing the amplitude of the disturbance signal at the input of the intermediate frequency circuit (2) to a level included in the dynamics of the undisturbed channels, the attenuators being switched in by closing interruptors (10) controlled by the control signals ($C_i$) and applying a variable amplitude signal to the attenuators.

7. A receiver according to claim 6, characterized in that the level of a disturbed carrier is brought, by the corresponding voltage controllable variable attenuator, to the level of the highest level carrier among the undisturbed carriers, the receiver comprising, for each channel, a circuit (91) for comparing the level of the detected carrier with the level of the detected undisturbed carrier of the highest level, the output of this circuit being connected via an interruptor (10) to the voltage control input of the attenuator.

**Patentansprüche**

1. Empfänger für Mehrfachträgersignale (Fig. 3), mit Hochfrequenz- und Zwischenfrequenzverstärkerkreisen (1 bzw. 2), die die Gesamtheit der n modulierten Träger verstärken, und mit einem Demodulationskreis (3), der für jeden modulierten Träger ein Filter (30, Fig. 1), einen Detektorverstärker (31, Fig. 1) mit Ausgängen für die detektierten Signale ($V_{di}$) und einen Demodulator (33, Fig. 1) aufweist, der Ausgänge für demodulierte Signale ($S_i$) besitzt, dadurch gekennzeichnet, daß der Empfänger zum Schutz gegen die Störsignale außerdem einen Kreis (6) zur Detektion der Störsignale, der an die Ausgänge ($V_{di}$, $S_i$, i = 1 bis n) des Demodulationskreises gekoppelt ist und für das Auftreten oder Verschwinden eines Störsignals auf jedem der Kanäle charakteristische Steuersignale ($C_i$) liefert, und einen Schaltkreis (5) zur Vorselektion und zur selektiven Dämpfung der Zwischenfrequenzträger aufweist, der zwischen den Hochfrequenzkreis (1) und den Zwischenfrequenzkreis eingefügt ist und auf die Zwischenfrequenzträger abgestimmte Filter (51) gefolgt von Dämpfungsgliedern (52) aufweist, die von den Steuersignalen ($C_i$) gesteuert werden, und daß der Empfänger außerdem einen Addierer (53) zum Addieren dieser Träger besitzt.

2. Empfänger nach Anspruch 1, in dem der Zwischenfrequenzverstärker von einem Schaltkreis zur automatischen Verstärkungssteuerung (4) gesteuert wird, dessen Eingänge an die Ausgänge der Detektorverstärker (31) angekoppelt sind und dessen Ausgang die größte aller Spannungen an diesen Ausgängen anzeigt, dadurch gekennzeichnet, daß er außerdem zwischen den Ausgängen der Detektorverstärker (31) und den Eingängen des Schaltkreises zur automatischen Verstärkungssteuerung (4) elektronisch gesteuerte Schalter (8) aufweist, die von den Steuersignalen ($C_i$) betätigt werden, um die Übertragung des auf einem gestörten Kanal detektierten Signals an den Schaltkreis zur automatischen Verstärkungssteuerung zu verhindern.

3. Empfänger nach einem der Ansprüche 1 und 2, der als Frequenzdiversity-Empfänger betrieben wird und einen Schaltkreis aufweist, in dem die demodulierten Träger kombiniert werden und der an die Ausgänge des Demodulationskreises angekoppelt ist, dadurch gekennzeichnet, daß elektronisch von den Steuersignalen ($C_i$) gesteuerte Schalter (7) zwischen den Ausgängen des Demodulationskreises und dem Kombinierschaltkreis liegen, um das Ausgangssignal eines gestörten Kanals zu annulieren.

4. Empfänger nach einem beliebigen der vorhergehenden Ansprüche, dadurch gekennzeichnet, daß der Schaltkreis (6) zur Detektion der Störungen für jeden Träger einen Schaltkreis (61, 62) zur Wiedergewinnung und Detektion des Taktsignals ($H_i$), dessen Eingang an den entsprechenden Ausgang ($S_i$) des Demodulationskreises angeschlossen ist, einen Komparator (63), dessen Eingänge an den entsprechenden Ausgang für das detektierte Signal ($V_{di}$) und an den Ausgang des Taktsignaldetektorschaltkreises angeschlossen ist, und einen Steuerschaltkreis (64) aufweist, der ausgehend von den relativen Pegeln des Taktsignals und des detektierten Signals das entsprechende Steuersignal ($C_i$) liefert.

5. Empfänger nach einem beliebigen der vorhergehenden Ansprüche, dadurch gekennzeichnet, daß die frequenzselektive durch das entsprechende Steuersignal beim Auftreten des Störsignals auf dem entsprecheden Träger gesteuerte Dämpfung eine Maximaldämpfung ist, wobei die Dämpfungsglieder (52) durch Schließen von durch die Steuersignale ($C_i$) gesteuerten Schaltern (10) eingeschaltet werden, und daß der Empfänger außerdem eine Teststeuervorrichtung für den Test des entsprechenden Trägers zu entsprechenden Zustandsänderung des Steuersignals beim Verschwinden des Störsignals aufweist.

6. Empfänger nach einem beliebigen der Ansprüche 1 bis 4, dadurch gekennzeichnet, daß die frequenzselektive Dämpfung, die vom entsprechenden Steuersignal beim Auftreten eines Störsignals auf dem entsprechenden Träger gesteuert wird, eine variable Dämpfung ist, die die Amplitude des Störsignals am Eingang des Zwischenfrequenzkreises (2) auf einen Pegel bringt, der in der Dynamik der nicht gestörten Kanäle liegt, wobei die Dämpfer in den Kreis durch Schließen von durch die Steuersignale ($C_i$) gesteuerte Schalter (10) eingefügt werden, die ein Signal variabler Amplitude an die Dämpfer anlegen.

7. Empfänger nach Anspruch 6, dadurch gekennzeichnet, daß der Pegel eines gestörten Trägers durch den entsprechenden spannungsgesteuerten variablen Dämpfer auf den Pegel desjenigen Trägers gebracht wird, dessen Pegel dem höchsten Pegel der nicht gestörten Träger entspricht, wobei der Empfänger für jeden Kanal einen Komparatorkreis (91) zum Vergleich des Pegels des detektierten Trägers mit dem Pegel des nicht gestörten Trägers höchsten Pegels aufweist, dessen Ausgang über einen Schalter (10) an den Spannungssteuereingang des Dämpfers angeschlossen ist.

0 093 651

Fig.1

Fig.2

Fig.3